# EUROPEAN PATENT SPECIFICATION

(11) **EP 4 417 987 B1**
(45) Date of publication and mention of the grant of the patent: **01.04.2026**
(21) Application number: 22901699.3
(22) Date of filing: 28.11.2022
(51) Int. Cl.: H02J 7/00, H01M 10/42

(54) **SYSTEM AND METHOD FOR MANAGING BATTERY INFORMATION**
SYSTEM UND VERFAHREN ZUR VERWALTUNG VON BATTERIEINFORMATIONEN
SYSTÈME ET PROCÉDÉ DE GESTION D'INFORMATIONS DE BATTERIE

(30) Priority: 03.12.2021 KR 20210172221
(43) Date of publication of application: 21.08.2024
(73) Proprietor: LG Energy Solution, Ltd., Seoul 07335 (KR)
(72) Inventor: SEO, Yu Gyung, Daejeon 34122 (KR); OH, Seung Take, Daejeon 34122 (KR)
(74) Representative: Plasseraud IP
(86) International application number: PCT/KR2022/018947
(87) International publication number: WO 2023/101341

(56) References cited:
- JP-B2- 5 664 362
- KR-A- 20140 035 799
- KR-A- 20140 035 799
- KR-A- 20190 005 408
- KR-A- 20200 136 733
- KR-A- 20200 136 733
- KR-B1- 101 726 930
- KR-B1- 101 741 304
- KR-B1- 101 916 682
- KR-B1- 101 916 682

## Description

### [TECHNICAL FIELD]

### CROSS-REFERENCE TO RELATED APPLICATION

This application claims priority to and the benefit of Korean Patent Application No. 10-2021-0172221 filed in the Korean Intellectual Property Office on December 3, 2021.

### TECHNICAL FIELD

Embodiments disclosed herein relate to a battery information management system and a battery information management method using the same.

### [BACKGROUND ART]

An energy storage system (ESS) is a system that stores electrical energy and manages the same for use when needed, and in general, an energy storage system installed in a power plant driving a large-scale energy grid or a building with high energy consumption includes hundreds to thousands of battery cells. To systematically manage these battery cells, multiple battery cells are integrated to constitute a battery module and multiple battery modules are integrated to constitute a battery rack. The energy storage system includes multiple battery racks, in which a module battery management system (MBMS) and a rack battery management system (RBMS) are installed to control each battery module and each battery rack and monitor states thereof and a battery system controller (BSC) is installed on a top layer to integratedly manage multiple battery-related information received from the MBMS and the RBMS.

The BSC needs to often (generally, every 1 seconds) monitor data related to several hundreds to several thousands of battery cells for a smooth operation of the energy storage system, and due to limitations in communication speed and data capacity to process all data, it is common to selectively receive and process only important data (e.g., a maximum/minimum cell voltage, a module temperature, a state of charge (SOC), etc.). However, in this case, all battery cells may not be precisely monitored, such that when abnormality occurs in the energy storage system, it is difficult to find a battery cell that causes the problem.
KR101741304B1 discloses a system and method for managing a battery cell using LC resonance. KR101726930B1 discloses a communication system and connecting method for communicating between battery management systems. KR101916682B1 discloses a background cell balancing system and method thereof. KR20140035799A discloses a battery system and energy storage system.

### [DISCLOSURE]

### [TECHNICAL PROBLEM]

Embodiments disclosed herein aim to provide a battery information management system and a battery information management method in which data of all battery cells constituting an energy storage system may be frequently monitored.

Embodiments disclosed herein aim to store information of all battery cells in a storage device, thereby making it possible to easily find a battery cell that causes abnormality when the abnormality occurs in a system.

Technical problems of the embodiments disclosed herein are not limited to the above-described technical problems, and other unmentioned technical problems would be clearly understood by one of ordinary skill in the art from the following description.

### [TECHNICAL SOLUTION]

A battery information management system according to an embodiment includes a communication device configured to receive information about a battery rack from a rack battery management system (RBMS) configured to control the battery rack, a switch connected to the communication device through a short-range communication network and configured to receive the information about the battery rack from the communication device, and a controller configured to receive the information about the battery rack from the switch.

In the battery information management system according to an embodiment, the battery rack may include at least one battery modules, each battery module may include at least one battery cell, and the information about the battery rack may include information about each battery cell.

In the battery information management system according to an embodiment, each battery module may be controlled by a module battery management system (MBMS), and the RBMS and the MBMS may be configured to transmit and receive the information about each battery cell by performing controller area network (CAN) communication.

In the battery information management system according to an embodiment, the communication device may be further configured to change CAN communication data between the RBMS and the MBMS into a TCP/IP packet and transmit the TCP/IP packet to the switch.

In the battery information management system according to an embodiment, the communication device may be further configured to be allocated with an IP using a dynamic host configuration protocol (DHCP) scheme and communicate with the switch based on the allocated IP, and the switch may be further configured to enable IP allocation using the DHCP scheme.

In the battery information management system according to an embodiment, the controller may be further configured to store the information about each battery cell in the storage device.

In the battery information management system according to an embodiment, a period for the controller to store the information about each battery cell may be within 1 second.

In the battery information management system according to an embodiment, the controller may be further configured to determine whether abnormality of a battery cell occurs, based on the information about each battery cell stored in the storage device.

An energy storage system according to an embodiment includes at least one battery racks, at least one rack battery management system (RBMS) configured to control each of the at least one battery racks, and a battery information management system configured to manage information about the at least one battery rack, in which the battery information management system includes at least one communication device configured to receive, from each RBMS, information about a battery rack controlled by the RBMS, a switch connected to the at least one communication device through a short-range communication network and configured to receive the information about the battery rack from the communication device, and a controller configured to receive the information about the battery rack from the switch.

In the energy storage system according to an embodiment, each battery rack may include at least one battery modules, each battery module may include at least one battery cell, and the information about the battery rack may include information about each battery cell.

The energy storage system according to an embodiment may further include at least one module battery management system (MBMS) configured to control each of the at least one battery modules, in which the RBMS and the MBMS are configured to transmit and receive the information about each battery cell by performing controller area network (CAN) communication.

In the energy storage system according to an embodiment, the communication device may be further configured to change CAN communication data between the RBMS and the MBMS into a TCP/IP packet and transmit the TCP/IP packet to the switch.

In the energy storage system according to an embodiment, the communication device may be further configured to be allocated with an IP using a dynamic host configuration protocol (DHCP) scheme and communicate with the switch based on the allocated IP, and the switch may be further configured to enable IP allocation using the DHCP scheme.

The energy storage system according to an embodiment may further include a storage device configured to store the information about each battery cell, in which the controller is further configured to store the information about each battery cell in the storage device.

In the energy storage system according to an embodiment, a period for the controller to store the information about each battery cell may be within 1 second.

In the energy storage system according to an embodiment, the controller may be further configured to determine whether abnormality of a battery cell occurs, based on the information about each battery cell stored in the storage device, when abnormality occurs in the energy storage system.

A battery information management method according to an embodiment includes receiving, by a communication device, information about a battery rack from a rack battery management system (RBMS) configured to control the battery rack, receiving, by a switch connected to the communication device through a short-range communication network, the information about the battery rack from the communication device, and receiving, by a controller, the information about the battery rack from the switch.

In the battery information management method according to an embodiment, the battery rack may include at least one battery modules, each battery module may include at least one battery cell, and the information about the battery rack may include information about each battery cell.

The battery information management method according to an embodiment may further include storing, by the controller, the information about each battery cell in a storage device.

The battery information management method according to an embodiment may further include determining, by the controller, whether abnormality of a battery cell occurs, based on the information about each battery cell stored in the storage device.

### [ADVANTAGEOUS EFFECTS]

According to an embodiment, there is provided a battery information management system capable of integratedly managing information of all battery cells by using a communication device connected to an RBMS controlling a battery rack and a switch receiving information about each battery cell from the communication device through a short-range communication network and delivering the information to a controller.

According to the proposed system, when compared to a conventional system where the controller directly collects battery-related information from the RBMS, information of all battery cells may be collected and managed regardless of communication speed and data capacity. Thus, when abnormality occurs in the system, a battery cell that causes the abnormality may be easily found and only the found battery cell/module may be replaced, thereby saving repair and maintenance costs.

Moreover, various effects recognized directly or indirectly from the disclosure may be provided.

### [DESCRIPTION OF DRAWINGS]

In order to more clearly describe technical solutions of embodiments disclosed herein or the prior art, the drawings required in the description of the embodiments are briefly introduced below. It should be understood that the following drawings are for the purpose of explaining the embodiments of the present specification and not for limiting purposes. In addition, representations of some components in the drawings may be exaggerated or omitted for clarity of explanation.
FIG. 1 is a block diagram showing a configuration of an energy storage system including a battery information management system according to an embodiment.
FIG. 2 is a block diagram showing a configuration of an energy storage system according to prior art.
FIG. 3 is a block diagram showing a configuration of a battery rack included in a power storage system according to an embodiment.
FIG. 4 is a flowchart of a battery information management method according to an embodiment.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

Although terms used herein are selected with general terms popularly used at present under the consideration of functions in the disclosure, the terms may vary according to the intention of those of ordinary skill in the art, custom, or introduction of new technology. In addition, in a specific case, the applicant voluntarily may select terms, and in this case, the meaning of the terms may be disclosed in a corresponding description part of the present specification. Therefore, the terms used herein should be defined not by the simple names of the terms but by the substantial meaning of the terms and the contents throughout the disclosure.

Terms defined in the present disclosure are used for only describing a specific exemplary embodiment and may not have an intention to limit the scope of other exemplary embodiments. It is to be understood that the singular forms include plural references unless the context clearly dictates otherwise.

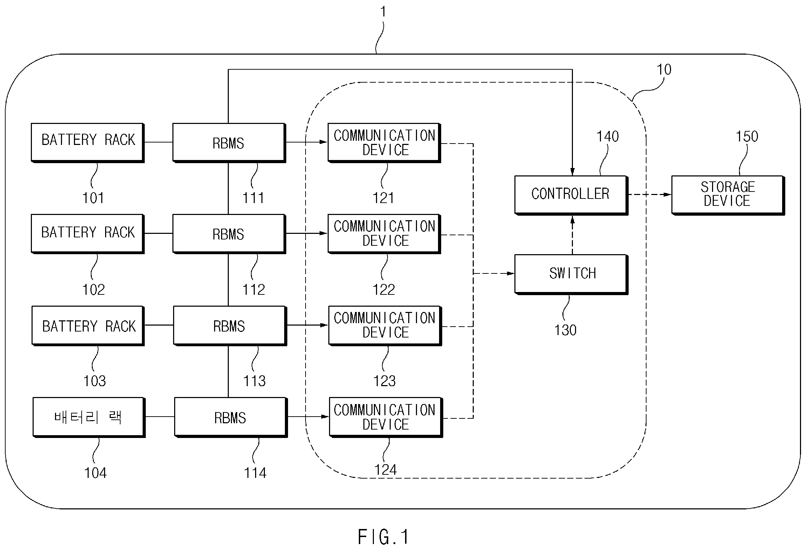

FIG. 1 is a block diagram showing a configuration of an energy storage system including a battery information management system according to an embodiment.

Referring to FIG. 1, an energy storage system 1 according to an embodiment may include a plurality of battery racks 101, 102, 103, and 104, a plurality of rack battery management systems (RBMSs) 111, 112, 113, and 114 respectively controlling the plurality of battery racks 101, 102, 103, and 104, a battery information management system 10 managing information about a battery, and a storage device 150 storing the information about the battery.

The battery information management system 10 according to an embodiment may include at least one communication device 121, 122, 123, and 124 receiving information about a battery rack from the RBMSs 111, 112, 113, and 114, a switch 130 receiving information about a battery rack from the communication device, and a controller 140 receiving the information about the battery rack from the switch 130.

While four battery racks 101, 102, 103, and 104, four RBMSs 111, 112, 113, and 114, and four communication devices 121, 122, 123, and 124 are shown in FIG. 1, they are merely an example configuration and more or less components may exist without being limited to the number of components shown.

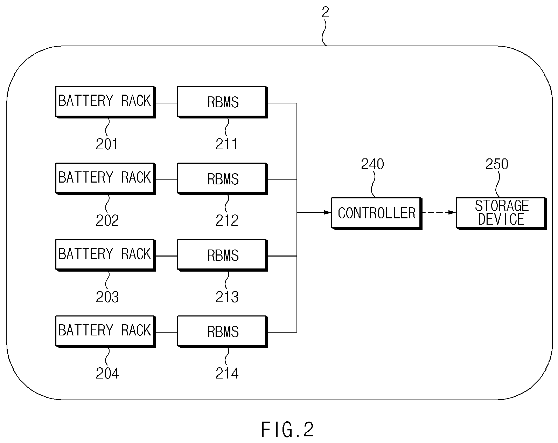

FIG. 2 is a block diagram showing a configuration of an energy storage system according to prior art. Referring to FIG. 2, an energy storage system 2 according to an embodiment includes a plurality of battery racks 201, 202, 203, and 204, a plurality of RBMSs 211, 212, 213, and 214 respectively controlling the plurality of battery racks 201, 202, 203, and 204, a controller 240 receiving information about a battery from the RBMS and managing the information, and a storage device 250 storing the information about the battery.

The biggest difference in structure of the energy storage system 1 according to an embodiment from the energy storage system 2 according to the prior art is including the additional communication devices 121, 122, 123, and 124 connected to each RBMS and the switch 130 that receives information about all batteries from the communication devices and deliver the information to the controller 140. These components collect and manage information related to a battery cell by performing communication using a scheme that is different from a conventional system.

The battery rack, which is a device for loading and managing a plurality of battery module sets, may be controlled by an RBMS installed on the battery rack. As shown in FIG. 1, the energy storage system 1 may include one or more battery racks 101, 102, 103, and 104, and the RBMSs 111, 112, 113, and 114 respectively installed on the battery racks may control the battery racks and collect information about a battery module included in the battery rack and information about a battery cell.

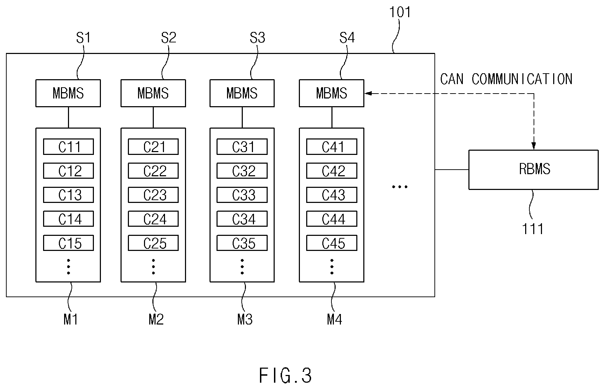

FIG. 3 is a block diagram showing a configuration of a battery rack included in an energy storage system according to an embodiment. Referring to FIG. 3, a battery rack 101 according to an embodiment may include at least one battery modules M1, M2, M3, M4, ... Each battery module M1 may include at least one battery cells C11, C12, C13, C14, C15...

Each of the battery cells C11, C12, C13, C14, C15,... is a basic unit of a battery to use electric energy by charging and discharging the electric energy, and is manufactured by putting components such as a cathode, an anode, a separator, an electrolyte, etc., into a pouch or a cylindrical or rectangular case. According to an embodiment, the battery cell may be a lithium ion (Li-ion) battery, an Li-ion polymer battery, a nickel-cadmium (Ni-Cd) battery, a nickel hydrogen (Ni-MH) battery, etc., and is not limited thereto.

The battery modules M1, M2, M3, M4, ... may respectively include a plurality of battery cells C11 - C15, C21 - C25, C31 - C35, C41 - C45, ..., and each may be an assembly that bundles a certain number of battery cells and puts them in a frame to protect them from external shock, heat, vibration, etc., and to manage information. The battery modules M1, M2, M3, M4, ... may be respectively controlled by module battery management systems (MBMSs) S1, S2, S3, S4, ... According to an embodiment, the MBMS S1 may control and manage the battery module M1 and collect information about the battery cells C11, C12, C13, C14, C15, ... constituting the battery module M1, e.g., voltage, current, temperature, resistance, a state of charge (SoC), a state of health (SoH), etc., of each battery cell and transmit the information to a module external device.

Referring to FIG. 3, the MBMSs S1, S2, S3, S4, ... may communicate with the RBMS 111 for controlling the battery rack 101 that is a parent group of battery modules controlled by each of them, and transmit state information of battery cells, collected in every specific periods (e.g., every 1 seconds), to the RBMS 111. According to an embodiment, the MBMSs S1, S2, S3, S4, ... and the RBMS 111 may exchange data with each other using a controller area network (CAN) communication scheme. The CAN communication, as a communication protocol standard designed to allow a controller or devices to communicate with each other within a system without a host computer, has the advantage of being very resistant to electrical noise and configuring a communication system at low prices. The CAN communication is merely an example and a communication scheme between an RBMS and an MBMS is not limited thereto.

Referring back to FIG. 1, the RBMSs 111, 112, 113, and 114 may receive information about a battery rack from the battery racks 101, 102, 103, 104 respectively connected thereto. More specifically, each of the RBMSs 111, 112, 113, and 114 may communicate with the MBMSs S1, S2, S3, S4, ..., that control the battery modules included in the battery rack, and receive information about a battery module and information about a battery cell from the MBMS. That is, information about a battery rack may include information about each battery cell included in the battery rack.

The at least one communication devices 121, 122, 123, and 124 constituting the battery information management system 10 may receive information about a battery rack including information about battery cells from each of the RBMSs 111, 112, 113, and 114. In this case, the RBMSs 111, 112, 113, and 114 and the communication devices 121, 122, 123, and 124 may communicate using the CAN communication scheme, without being limited thereto. The communication devices 121, 122, 123, and 124 may transmit information about each battery rack to the switch 130 by using a short-range communication network.

According to an embodiment, the communication devices 121, 122, 123, and 124, as CAN-to-Ethernet communication devices, may change a CAN message including battery information received from an RBMS into a TCP/IP packet and transmit the TCP/IP packet to the switch 130 through an Ethernet communication network. To this end, the communication device and the switch may be connected wiredly or through a wireless local area network (LAN), and may transmit and receive several tens or several thousands of Mbits of data per second at an even longer distance than CAN communication. While it is described in an embodiment that the communication device and the switch transmit and receive data by using the Ethernet communication network and a TCP/IP protocol, communication is not limited to the above-described communication scheme.

The switch 130 may receive information about a battery rack (including information about a battery cell) from the communication devices 121, 122, 123, and 124 through a short-range communication network (e.g., Ethernet). According to an embodiment, the switch 130 may receive battery-related information in a TCP/IP packet form from the communication devices and transmit the information to the controller 140 in the TCP/IP packet form through the Ethernet communication network. As shown in FIG. 1, the switch 130 may serve as a switch hub that receives information from the plurality of communication devices 121, 122, 123, and 124 connected through multiple ports and selectively, sequentially, or simultaneously delivers the information to the controller 140.

According to an embodiment, the communication devices 121, 122, 123, and 124 may be allocated with an IP using a dynamic host configuration protocol (DHCP) scheme and communicate with the switch 130 based on the allocated IP, and the switch 130 may be further configured to enable IP allocation using the DHCP scheme. That is, the switch 130 may automatically allocate an IP to a communication device that needs the IP and may receive the IP to allow another device to use the IP when the communication device does not use the IP.

The controller 140 may receive information about a battery rack (including information about a battery cell) from the switch 130. As described above, the information may be received in the TCP/IP packet form through the Ethernet communication network, without being limited thereto. The controller 140 may include an arithmetic unit for processing information delivered from a low-level battery management system (an MBMS, an RBMS, etc.) and a control unit for controlling the low-level battery management system (the MBMS and the RBMS) based on a processing result, and may be a battery system controller (BSC) used in a general battery control system.

According to an embodiment, the controller 140 may receive information from the switch 130 through the short-range communication network (e.g., Ethernet) (see a dotted line connecting the switch to the controller in FIG. 1) and at the same time or selectively directly receive information about a battery rack from the RBMSs 111, 112, 113, and 114 (see a solid line connecting the RBMS to the controller). For direct communication with the RBMS, the CAN communication scheme may be used instead of Ethernet.

Referring back to FIG. 1, the energy storage system 1 according to an embodiment may further include the storage device 150 configured to store the information about each battery cell, in which the controller 140 may be further configured to store the information about each battery cell in the storage device 150. The storage device 150 may be various types of a storage medium such as semiconductor memory like RAM, ROM, flash memory, etc., a magnetic disk, an optical disk, and so forth, and may be a concept including additional devices capable of performing processing, transmitting, and displaying operations for data together with the storage medium. According to another embodiment, the storage device 150 may be a device or system (e.g., an external terminal, a cloud server, etc., connected through a network) located outside the energy storage system 1.

According to an embodiment, the controller 140 may store CAN-to-Ethernet transmission data in every periods in the storage device 150 by using a logging program installed in the system (e.g., ModuleLogReceiver^{®} developed by LGES). A period in which the controller 140 stores information about each battery cell may be set to be, preferably, but not limited thereto, within 1 second.

As shown in FIG. 2, in the energy storage system 2 according to prior art, the controller 240 receives information from the RBMSs 211, 212, 213, and 214 through direct communication such as CAN communication. However, in case of CAN communication, due to limitations in communication speed and data capacity, there is no choice but to selectively receive only important data of a battery (e.g., a maximum/minimum cell voltage, a module temperature, an SoC, etc.). On the other hand, the energy storage system 1 according to an embodiment shown in FIG. 1 delivers information to the controller 140 through a short-range communication network such as Ethernet by using the additional communication devices 121, 122, 123, and 124 respectively connected to RBMSs and the switch 130, thereby overcoming the limitations of the communication speed and the data capacity and collecting and managing information about all battery cells.

In this way, by recording all battery cell data in real time, it is possible to easily respond when abnormality occurs in the energy storage system. For example, when abnormality occurs in the energy storage system 1, the controller 140 may read information about each battery cell, stored in the storage device 150, to determine whether abnormality occurs in the battery cell. In this case, correlation between abnormality of the entire system and abnormality of the battery cell may be determined according to a predetermined criterion or based on an input from a manager. When it is determined that abnormality occurs in the battery cell, a position of the battery (a position of a specific battery rack in a specific battery module) and state record information may be transmitted to a manager terminal. The manager may greatly reduce repair cost and time for the energy storage system by replacing only a specified abnormal battery cell.

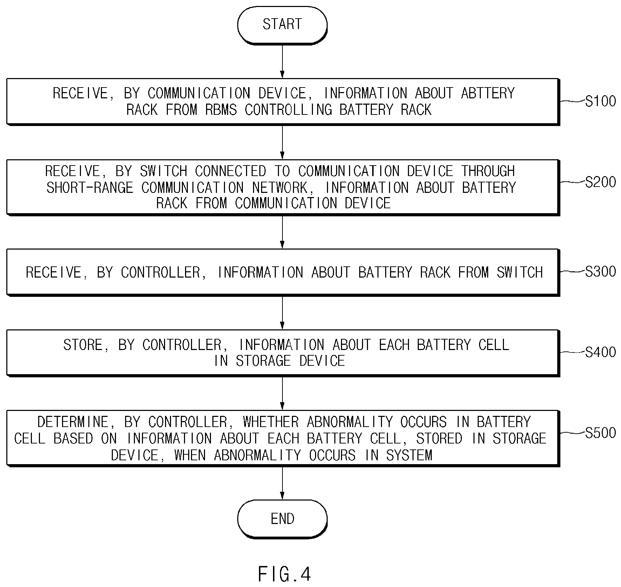

FIG. 4 is a flowchart of a battery information management method according to an embodiment. Referring to FIG. 4, operation S100 is performed in which a communication device receives information about a battery rack from an RBMS controlling the battery rack. As described above, the energy storage system may include at least one battery rack, each of which may be controlled by at least one RBMS. As described with reference to FIG. 3, each battery rack may include at least one battery module, each of which may include at least one battery cell. The information about the battery rack collected by the RBMS may include information about an individual battery cell, e.g., voltage, current, temperature, resistance, SoC, SoH, etc., of each battery cell. The RBMS that manages a battery rack and the MBMS that manages a battery module may transmit and receive data using the CAN communication scheme, and each communication device and the RBMS may also transmit and receive data using the CAN communication scheme.

Next, operation S200 is performed in which a switch connected to the communication device through a short-range communication network receives the information about the battery rack (including the information about the battery cell) from the communication device. According to an embodiment, the communication device, as CAN-to-Ethernet communication devices, may change a CAN message including battery information received from an RBMS into a TCP/IP packet and transmit the TCP/IP packet to the switch through an Ethernet communication network. The switch may serve as a switch hub that receives information from a plurality of communication devices connected through multiple ports and selectively, sequentially, or simultaneously delivers the information to a controller. The switch may also be configured to enable IP allocation to a required communication device by supporting a DHCP function.

Next, operation S300 is performed in which the controller receives the information about the battery rack (including the information about the battery cell) from the switch. According to an embodiment, the switch may transmit the information in a TCP/IP packet form to the controller through a short-range communication network (e.g., Ethernet). The controller may include an arithmetic unit for processing information delivered from a low-level battery management system (an MBMS, an RBMS, etc.) and a control unit for controlling the low-level battery management system (the MBMS and the RBMS) based on a processing result, and may be a BSC used in a general battery control system.

Next, operation S400 is performed in which the controller stores information about each battery cell in the storage device. The storage device may be various types of a storage medium such as semiconductor memory like RAM, ROM, flash memory, etc., a magnetic disk, an optical disk, and so forth, and may be a concept including additional devices capable of performing processing, transmitting, and displaying operations for data together with the storage medium. The controller may receive information about all battery cells in every predetermined periods (preferably, every 1 seconds or less) and record the information in the storage device.

According to an embodiment, the battery information management method may further include operation S500 in which the controller determines whether abnormality of a battery cell occurs, based on the information about each battery cell stored in the storage device. In this way, by recording all battery cell data in the storage device, it is possible to easily respond when abnormality occurs in the energy storage system. When it is determined that abnormality occurs in the battery cell, a position of the battery (a position of a specific battery rack in a specific battery module) and state record information may be transmitted to a manager terminal, and the manager may replace only a specified abnormal battery cell, thereby largely reducing repair cost and time for the energy storage system.

The battery information management method according to the embodiments may be connecting implemented in the form of an application or a program instruction that is executable through various computer components and recorded in a computer-readable recording medium. The computer-readable recording medium may include a program instruction, a data file, a data structure and the like solely or in a combined manner.

So far, all components constituting the embodiment have been described as being combined or operating in combination, but it is not necessarily limited to this embodiment, and within the scope of the purpose, all components may be selectively combined with one or more to operate. Moreover, terms such as "include", "constitute", "have", etc., described above may mean that the corresponding component may be inherent unless otherwise stated, and thus should be construed as further including other components rather than excluding other components.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

### List of reference numbers

1, 2: Energy Storage System
10: Battery Information Management System
101, 102, 103, 104, 201, 202, 203, 204: Battery Rack
111, 112, 113, 114, 211, 212, 213, 214: RBMS
121, 122, 123, 124: Communication Device
130: Switch
140, 240: Controller
150, 250: Storage Device
M1, M2, M3, M4: Battery Module
S1, S2, S3, S4: MBMS
C11 - C15, C21 - C25, C31 - C35, C41 - C45: Battery Cell

## Claims

1. A battery information management system (10) comprising:
a communication device (121, 122, 123, 124) configured to receive information about a battery rack (101, 102, 103, 104) from a rack battery management system (111, 112, 113, 114), RBMS, configured to control the battery rack;
a switch (130) connected to the communication device through a short-range communication network and configured to receive the information about the battery rack from the communication device; and
a controller (140) configured to receive the information about the battery rack from the switch.

2. The battery information management system of claim 1, wherein the battery rack comprises at least one battery modules (M1, M2, M3, M4),
each battery module comprises at least one battery cell (C11-C15, C21-C25, C31-C35, C41-C45), and
the information about the battery rack comprises information about each battery cell.

3. The battery information management system of claim 2, wherein each battery module is controlled by a module battery management system (S1, S2, S3, S4), MBMS, and
the RBMS and the MBMS are configured to transmit and receive the information about each battery cell by performing controller area network, CAN, communication.

4. The battery information management system of claim 3, wherein the communication device is further configured to change CAN communication data between the RBMS and the MBMS into a TCP/IP packet and transmit the TCP/IP packet to the switch.

5. The battery information management system of claim 4, wherein the communication device is further configured to be allocated with an **IP** using a dynamic host configuration protocol, DHCP, scheme and communicate with the switch based on the allocated IP, and
the switch is further configured to enable IP allocation using the DHCP scheme.

6. The battery information management system of claim 2, wherein the controller is further configured to store the information about each battery cell in the storage device.

7. The battery information management system of claim 6, wherein a period for the controller to store the information about each battery cell is within 1 second.

8. The battery information management system of claim 6, wherein the controller is further configured to determine whether abnormality of a battery cell occurs, based on the information about each battery cell stored in the storage device.

9. An energy storage system (1) comprising:
at least one battery rack;
at least one rack battery management system, RBMS, configured to control the at least one battery rack; wherein the energy storage system comprises the battery information management system according to one of Claims 1 to 8, wherein the battery information management system is configured to manage information about the at least one battery rack.

10. A battery information management method comprising
receiving (S100), by a communication device, information about a battery rack from a rack battery management system, RBMS, configured to control the battery rack;
receiving (S200), by a switch connected to the communication device through a short-range communication network, the information about the battery rack from the communication device; and
receiving (S300), by a controller, the information about the battery rack from the switch.

11. The battery information management method of claim 10, wherein the battery rack comprises at least one battery modules,
each battery module comprises at least one battery cell, and
the information about the battery rack comprises information about each battery cell.

12. The battery information management method of claim 11, further comprising storing (S400), by the controller, the information about each battery cell in a storage device (150).

13. The battery information management method of claim 12, further comprising determining (S500), by the controller, whether abnormality of a battery cell occurs, based on the information about each battery cell stored in the storage device.

## Patentansprüche

1. Batterieinformationsmanagementsystem (10), umfassend:
eine Kommunikationsvorrichtung (121, 122, 123, 124), welche dazu eingerichtet ist, Informationen über ein Batterierack (101, 102, 103, 104) von einem Rack-Batteriemanagementsystem (111, 112, 113, 114), RBMS, zu empfangen, welches dazu eingerichtet ist, das Batterierack zu steuern;
einen Schalter (130), welcher über ein Kurzstrecken-Kommunikationsnetzwerk mit der Kommunikationsvorrichtung verbunden ist und dazu eingerichtet ist, die Informationen über das Batterierack von der Kommunikationsvorrichtung zu empfangen; und
eine Steuereinheit (140), welche dazu eingerichtet ist, die Informationen über das Batterierack von dem Schalter zu empfangen.

2. Batterieinformationsmanagementsystem nach Anspruch 1, wobei das Batterierack wenigstens ein Batteriemodul (M1, M2, M3, M4) umfasst,
wobei jedes Batteriemodul wenigstens eine Batteriezelle (C11-C15, C21-C25, C31-C35, C41-C45) umfasst, und
wobei die Informationen über das Batterierack Informationen über jede Batteriezelle umfassen.

3. Batterieinformationsmanagementsystem nach Anspruch 2, wobei jedes Batteriemodul durch ein Modul-Batteriemanagementsystem (S1, S2, S3, S4), MBMS, gesteuert ist, und
wobei das RBMS und das MBMS dazu eingerichtet sind, die Informationen über jede Batteriezelle durch ein Durchführen einer Controller-Area-Network-, CAN, Kommunikation zu übertragen und zu empfangen.

4. Batterieinformationsmanagementsystem nach Anspruch 3, wobei die Kommunikationsvorrichtung ferner dazu eingerichtet ist, CAN-Kommunikationsdaten zwischen dem RBMS und dem MBMS in ein TCP/IP-Paket zu ändern und das TCP/IP-Paket an den Schalter zu übertragen.

5. Batterieinformationsmanagementsystem nach Anspruch 4, wobei die Kommunikationsvorrichtung ferner dazu eingerichtet ist, unter Verwendung eines Dynamic-Host-Configuration-Protocol-,DHCP, Schemas einer **IP** zugewiesen zu werden und basierend auf der zugewiesenen **IP** mit dem Schalter zu kommunizieren, und
wobei der Schalter ferner dazu eingerichtet ist, eine IP-Zuweisung unter Verwendung des DHCP-Schemas zu ermöglichen.

6. Batterieinformationsmanagementsystem nach Anspruch 2,
wobei die Steuereinheit ferner dazu eingerichtet ist, die Informationen über jede Batteriezelle in der Speichervorrichtung zu speichern.

7. Batterieinformationsmanagementsystem nach Anspruch 6, wobei ein Zeitraum für die Steuereinheit für ein Speichern der Informationen über jede Batteriezelle innerhalb von 1 Sekunde liegt.

8. Batterieinformationsmanagementsystem nach Anspruch 6, wobei die Steuereinheit ferner dazu eingerichtet ist, basierend auf den Informationen über jede Batteriezelle, welche in der Speichervorrichtung gespeichert sind, zu bestimmen, ob eine Anomalie einer Batteriezelle auftritt.

9. Energiespeichersystem (1), umfassend:
wenigstens ein Batterierack;
wenigstens ein Rack-Batteriemanagementsystem, RBMS, welches dazu eingerichtet ist, das wenigstens eine Batterierack zu steuern,
wobei das Energiespeichersystem das
Batterieinformationsmanagementsystem nach einem der Ansprüche 1 bis 8 umfasst,
wobei das Batterieinformationsmanagementsystem dazu eingerichtet ist, Informationen über das wenigstens eine Batterierack zu verwalten.

10. Batterieinformationsmanagementverfahren, umfassend:
Empfangen (S100), durch eine Kommunikationsvorrichtung, von Informationen über ein Batterierack von einem Rack-Batteriemanagementsystem, RBMS, welches dazu eingerichtet ist, das Batterierack zu steuern;
Empfangen (S200), durch einen Schalter, welcher über ein Kurzstrecken-Kommunikationsnetzwerk mit der Kommunikationsvorrichtung verbunden ist, der Informationen über das Batterierack der Kommunikationsvorrichtung;
und
Empfangen (S300), durch eine Steuereinheit, der Informationen über das Batterierack von dem Schalter.

11. Batterieinformationsmanagementverfahren nach Anspruch 10, wobei das Batterierack wenigstens ein Batteriemodul umfasst,
wobei jedes Batteriemodul wenigstens eine Batteriezelle umfasst, und
wobei die Informationen über das Batterierack Informationen über jede Batteriezelle umfassen.

12. Batterieinformationsmanagementverfahren nach Anspruch 11, ferner umfassend ein Speichern (S400), durch die Steuereinheit, der Informationen über jede Batteriezelle in einer Speichervorrichtung (150).

13. Batterieinformationsmanagementverfahren nach Anspruch 12, ferner umfassend ein Bestimmen (S500), durch die Steuereinheit, ob eine Anomalie einer Batteriezelle auftritt, basierend auf den Informationen über jede Batteriezelle, welche in der Speichervorrichtung gespeichert sind.

## Revendications

1. Système (10) de gestion d'informations de batterie comprenant :
un dispositif de communication (121, 122, 123, 124) configuré pour recevoir des informations concernant un rack de batterie (101, 102, 103, 104) à partir d'un système de gestion de batterie de rack (111, 112, 113, 114), RBMS, configuré pour contrôler le rack de batterie ;
un commutateur (130) connecté au dispositif de communication par le biais d'un réseau de communication à courte portée et configuré pour recevoir les informations concernant le rack de batterie à partir du dispositif de communication ; et
un contrôleur (140) configuré pour recevoir les informations concernant le rack de batterie à partir du commutateur.

2. Système de gestion d'informations de batterie selon la revendication 1, dans lequel
le rack de batterie comprend au moins un module de batterie (M1, M2, M3, M4),
chaque module de batterie comprend au moins une cellule de batterie (C11-C15, C21-C25, C31-C35, C41-C45), et
les informations concernant le rack de batterie comprennent des informations concernant chaque cellule de batterie.

3. Système de gestion d'informations de batterie selon la revendication 2, dans lequel
chaque module de batterie est contrôlé par un système de gestion de batterie de module (S1, S2, S3, S4), MBMS, et
le RBMS et le MBMS sont configurés pour transmettre et recevoir les informations concernant chaque cellule de batterie en réalisant une communication par réseau de zone de contrôleur, CAN.

4. Système de gestion d'informations de batterie selon la revendication 3, dans lequel le dispositif de communication est en outre configuré pour changer des données de communication CAN entre le RBMS et le MBMS en un paquet TCP/IP et transmettre le paquet TCP/IP au commutateur.

5. Système de gestion d'informations de batterie selon la revendication 4, dans lequel le dispositif de communication est en outre configuré pour se voir alloué un IP à l'aide d'un schéma de protocole de configuration dynamique des hôtes dynamique, DHCP, et communiquer avec le commutateur sur la base de l'IP alloué, et
le commutateur est en outre configuré pour activer l'allocation d'IP à l'aide du schéma DHCP.

6. Système de gestion d'informations de batterie selon la revendication 2, dans lequel le contrôleur est en outre configuré pour stocker les informations concernant chaque cellule de batterie dans le dispositif de stockage.

7. Système de gestion d'informations de batterie selon la revendication 6, dans lequel une période pendant laquelle le contrôleur stocke les informations concernant chaque cellule de batterie est inférieure à 1 seconde.

8. Système de gestion d'informations de batterie selon la revendication 6, dans lequel le contrôleur est en outre configuré pour déterminer si une anomalie d'une cellule de batterie se produit, sur la base des informations concernant chaque cellule de batterie stockées dans le dispositif de stockage.

9. Système de stockage d'énergie (1) comprenant :
au moins un rack de batterie ;
au moins un système de gestion de batterie de rack, RBMS, configuré pour contrôler l'au moins un rack de batterie ;
dans lequel le système de stockage d'énergie comprend le système de gestion d'informations de batterie selon l'une des revendications 1 à 8, dans lequel le système de gestion d'informations de batterie est configuré pour gérer des informations concernant l'au moins un rack de batterie.

10. Procédé de gestion d'informations de batterie, comprenant
la réception (S100), par un dispositif de communication, d'informations concernant un rack de batterie à partir d'un système de gestion de batterie de rack, RBMS, configuré pour contrôler le rack de batterie ;
la réception (S200), par un commutateur connecté au dispositif de communication par le biais d'un réseau de communication à courte portée, des informations concernant le rack de batterie à partir du dispositif de communication ; et
la réception (S300), par un contrôleur, des informations concernant le rack de batterie à partir du commutateur.

11. Procédé de gestion d'informations de batterie selon la revendication 10, dans lequel le rack de batterie comprend au moins un module de batterie,
chaque module de batterie comprend au moins une cellule de batterie, et
les informations concernant le rack de batterie comprennent des informations concernant chaque cellule de batterie.

12. Procédé de gestion d'informations de batterie selon la revendication 11, comprenant en outre le stockage (S400), par le contrôleur, des informations concernant chaque cellule de batterie dans un dispositif de stockage (150).

13. Procédé de gestion d'informations de batterie selon la revendication 12, comprenant en outre le fait de déterminer (S500), par le contrôleur, si une anomalie d'une cellule de batterie se produit, sur la base des informations concernant chaque cellule de batterie stockées dans le dispositif de stockage.
